# EUROPÄISCHE PATENTSCHRIFT

(11) **EP 1 603 330 B1**
(45) Veröffentlichungstag und Bekanntmachung des Hinweises auf die Patenterteilung: **22.12.2010**
(21) Anmeldenummer: 05011782.9
(22) Anmeldetag: 01.06.2005
(51) Int. Cl.: H04N 5/30

(54) **Verfahren und Vorrichtung zur Rekonstruktion und Regelung der Phasenlage eines Abtasttaktes bezüglich eines abzutastenden analogen Signals**
Method and device for reconstructing and regulating the phase position of a sample clock regarding an analog signal to be sampled
Procédé et dispositif de réconstruction et régulation de la position de phase d'une horloge d'échantillonnage concernant un signal analogique sous balayage

(30) Priorität: 02.06.2004 DE 102004027093
(43) Veröffentlichungstag der Anmeldung: 07.12.2005
(73) Patentinhaber: Micronas GmbH, 79108 Freiburg i. Br. (DE)
(72) Erfinder: Waldner, Markus, 9020 Klagenfurt (AT)
(74) Vertreter: Koch Müller Patentanwaltsgesellschaft mbH

(56) Entgegenhaltungen:
- US-A1- 2003 185 332
- REINHARDT,FRITZ ET AL.: "dtv-Atlas Mathematik 2 - Analysis und angewandte Mathematik" 1. Januar 1998 (1998-01-01), DTV , XP002447613 ISBN: 3-423-03008-9 * Seite 312 - Seite 317 *

## Beschreibung

Die Erfindung betrifft ein Verfahren sowie eine Vorrichtung, mit welchen die Phasenlage eines Abtasttaktes bezüglich eines analogen Signals, welches abgetastet werden soll, rekonstruiert und geregelt werden kann.

Bei der Aufbereitung bzw. der Auswertung analoger Signale, insbesondere analoger Videosignale, werden diese oft gekoppelt abgetastet. Im Fall analoger Videosignale erfolgt insbesondere oft eine zeilengekoppelte Abtastung. Dies bedeutet, dass das analoge Signal genau mit der Abtastfrequenz (auch als Pixelfrequenz bezeichnet) der auf einem Schirm oder Monitor darzustellenden Pixel abgetastet wird, wobei jedes einzelne Pixel einmal abgetastet bzw. gesampled wird.

Bei der gekoppelten Abtastung analoger Signale ist jedoch nicht nur die Abtast- oder Pixelfrequenz von Bedeutung, sondern auch die Phasenlage des Abtasttaktes bezüglich des abzutastenden Signals, beispielsweise eines Pixelsignals. Aus diesem Grund ist die Synchronisation des Abtasttaktes mit dem analogen Signal erforderlich. Zudem muss die Phasenlage, zumindest sofern eine geeignete vorliegt, konstant gehalten werden.

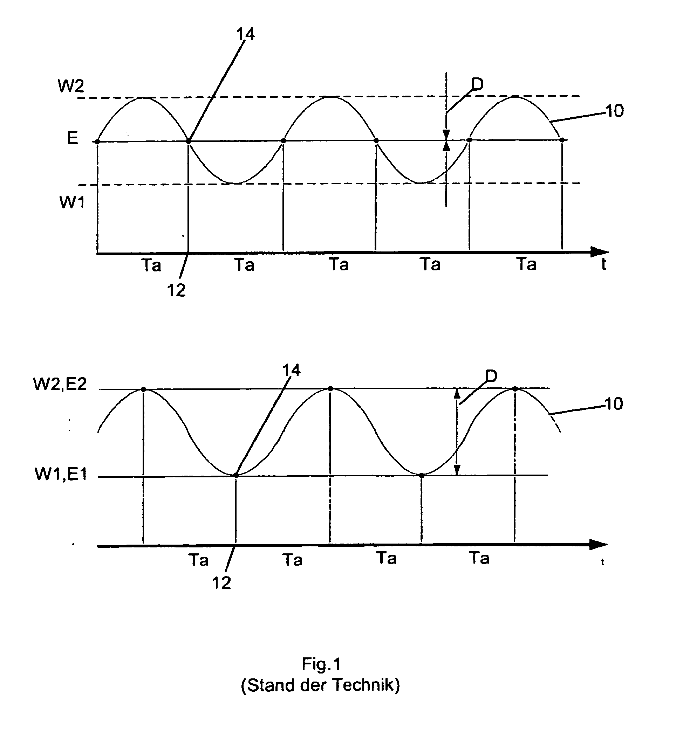

Erfolgt dies nicht, so kann eine ungünstige Phasenlage, wie im oberen Graphen der Figur 1 dargestellt, zu einer künstlichen Verschlechterung des Signals führen. Der hierin dargestellte Verlauf eines analogen Signals 10 trägt die Information sich abwechselnder Signalwerte W1 und W2. Bei Videoanwendungen könnte beispielsweise dem Signalwert W1 ein schwarzer Pixel zugeordnet sein, dem Signalwert W2 hingegen ein weißer Pixel. Das analoge Signal 10 wird im zeitlichen Abstand von Ta, welcher die inverse Abtastfrequenz darstellt, zu verschiedenen Abtastzeitpunkten 12 abgetastet, wobei die durch Punkte dargestellten Abtastwerte 14 erhalten werden.

Im Fall der in der oberen Darstellung von Figur 1 gezeigten Phasenlage erhält man zu jedem Abtastzeitpunkt denselben Abtastwert, so dass sich Abtastergebnisse E ergeben, welche keinem der Signalwerte W1 oder W2 zuordenbar sind. Bezogen auf das Schwarz-Weiß-Beispiel erhält man gleichermaßen einen Grauwert, der weder einen schwarzen noch einen weißen Pixel repräsentiert. Dies beruht darauf, dass die Trennung der Abtastergebnisse D den Wert 0 annimmt. Im Fall der im oberen Graphen dargestellten ungünstigsten Phasenlage des Abtasttaktes zum analogen Signal wäre demnach eine Trennung der Signalwerte W1 und W2 nicht möglich.

Der untere Graph in Figur 1 hingegen illustriert den Sachverhalt bei optimaler Phasenlage des Abtasttaktes bezüglich des analogen Signals 10. Die Abtastwerte 14 differieren um die maximal mögliche Trennung der Abtastergebnisse D, so dass sich Abtastergebnisse E1 ergeben, welche eindeutig dem Signalwert W1 zuordenbar sind, und Abtastergebnisse E2, die zweifelsfrei zu dem Signalwert W2 gehören. Dementsprechend ist die Phasenlage des Abtasttaktes bezüglich des analogen Signals und somit die erwähnte Synchronisation von erheblicher Bedeutung für die Auswertbarkeit des Signals.

Bei einer analogen Videosignalabtastung wird die erforderliche Synchronisation oftmals dadurch realisiert, dass ein Phasenregelkreis (phase locked loop - PLL), mit welchem die Phasenlage des Abtasttaktes geregelt wird, auf einen Zeitsynchronisierimpuls, auch als H-Sync bezeichnet, synchronisiert wird, welcher bei Videosignalen üblicherweise übertragen wird. Bei Videosignalen von Computern kommt es aber beispielsweise vor, dass Pixel gegenüber dem H-Sync in ihrer Phase verschoben sind. Dies macht eine Phasenkorrektur des Abtasttaktes erforderlich.

In dem genannten Beispiel wie auch im allgemeinen ist jedoch der Betrag der Phasenabweichung des Signals vom Abtasttakt bzw., wenn vorhanden, von einem Synchronisierimpuls nicht bekannt, da durch die gekoppelte Abtastung nur ein Abtastpunkt pro abzutastendem Signal, insbesondere bei der zeilengekoppelten Abtastung eines analogen Videosignals nur ein Abtastwert pro Pixel, zur Verfügung steht.

Als weiterer Stand der Technik wird die US 2003/185332 A1 zitiert.

Der Erfindung liegt somit das Problem zu Grunde, ein Verfahren zur Verfügung zu stellen, mit welchem die Phasenlage des Abtasttaktes bezüglich des abzutastenden analogen Signals einfach und zuverlässig bestimmt und geregelt werden kann.

Weiterhin liegt der Erfindung das Problem zu Grunde, eine Vorrichtung zur Verfügung zu stellen, mit welcher ein solches Verfahren praktisch umsetzbar ist.

Die genannten Probleme werden erfindungsgemäß gelöst durch ein Verfahren mit den Merkmalen des Anspruchs 1 bzw. eine Vorrichtung mit den Merkmalen des Anspruch 10.

Vorteilhafte Weiterbildungen der Erfindung sind Gegenstand abhängiger Unteransprüche.

Die der Erfindung zu Grunde liegende Idee besteht darin, neben den üblichen Abtast- bzw. Samplewerten noch zusätzlich zu verschiedenen Zeitpunkten zeitliche Gradienten des analogen Signals zu bestimmen bzw. abzutasten, aus den bestimmten Samplewerten und den ermittelten zeitlichen Gradienten das ursprünglich analoge Signal wenigstens abschnittsweise zu rekonstruieren, mit Hilfe des rekonstruierten Signalverlaufs die Phasenlage des Abtasttaktes bezüglich des analogen Signals zu bestimmen und diese einer Regelschleife zuzuführen, welche die Phasenlage in geeigneter Weise nachregelt.

Auf diese Weise kann die Phasenlage des Abtasttaktes bezüglich des abzutastenden Signals einfach und zuverlässig bestimmt werden, ohne dass hierfür der Einsatz zusätzlicher Referenzsignale notwendig ist oder eine erhöhte Belastung der Vorrichtungselektronik eintritt. Unabhängig vom analogen Signal ist die Phasenlage des Abtasttaktes bezüglich des analogen Signals in ausreichender Genauigkeit bestimmbar und in eine Regelschleife einbindbar. Zudem kann ein Phasenabgleich nicht nur bei statischen Bildern, sondern auch bei bewegten Bildern durchgeführt werden. Da ein möglicher Phasensprung unmittelbar korrigiert werden kann, beispielsweise innerhalb einer Zeile bei Videosignalen, bleibt die Auswertung bzw. das Bild scharf und kontrastreich und ein Phasensprung würde von einem Beobachter, beispielsweise an einem Monitor, in der Regel nicht bemerkt werden.

Im Folgenden wird die Erfindung anhand eines Ausführungsbeispiels und unter Bezugnahme auf Figuren näher erläutert. Es zeigen:
- Figur 1: aus dem Stand der Technik bekannter und bereits behandelter Einfluss der Phasenlage des Abtasttaktes bezüglich des abzutastenden analogen Signals auf die Verwertbarkeit bzw. Güte der Abtastergebnisse,
- Figur 2: Einfluss der Phasenlage auf die zeitlichen Gradienten des analogen Signals in den Abtastzeitpunkt,
- Figur 3: sinusoidaler Abschnitt eines analogen Signals sowie polynominale Rekonstruktion dieses Abschnitts bei ungünstigster Phasenlage,
- Figur 4: sinusoidaler Abschnitt eines analogen Signals sowie polynominale Rekonstruktion bei günstigster Phasenlage,
- Figur 5: weiteres Beispiel eines Ausschnitts aus einem analogen Signal sowie dessen Rekonstruktion bei ungünstigster Phasenlage,
- Figur 6: weiteres Beispiel eines Ausschnitts aus einem analogen Signal sowie dessen Rekonstruktion bei günstigerer Phasenlage,
- Figur 7: größerer, nicht periodischer Ausschnitt aus einem abzutastenden analogen Signal,
- Figur 8: Diskretisierung des Signalausschnitts aus Figur 7 anhand der Abtastwerte sowie der zu den Abtastzeitpunkten vorliegenden zeitlichen Gradienten,
- Figur 9: vergrößerte Darstellung des in Figur 8 markierten Bereichs,
- Figur 10: Transformation der Werte aus Figur 9 in einen für die Auswertung günstigen Wertebereich,
- Figur 11: Differenz Δϕ der aktuellen Phasenlage zur idealen Phasenlage,
- Figur 12: Blockschaltbild einer erfindungsgemäßen Vorrichtung zur Rekonstruktion und Regelung der Phasenlage eines Abtasttaktes bezüglich eines abzutastenden analogen Signals,
- Figur 13: Detaildarstellung des Moduls zur Bestimmung der Phasenlage (60) aus Figur 12.

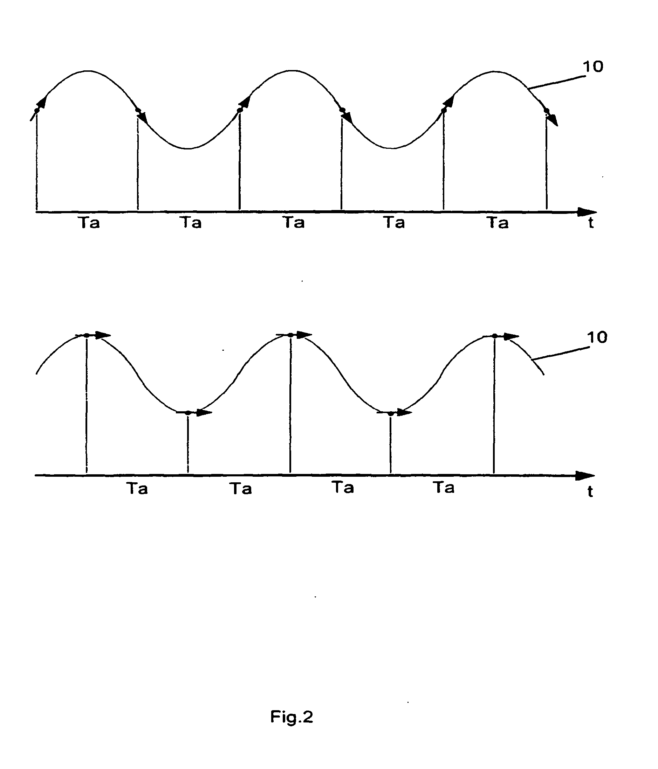

Im vorliegenden Ausführungsbeispiel wird das analoge Signal 10 wie in Figur 2 dargestellt mit dem Abtasttakt Ta, welcher die inverse Abtastfrequenz darstellt, äquidistant abgetastet. Eine kontinuierliche Abtastung mit dieser Frequenz ist jedoch nicht zwingend erforderlich. Im Prinzip genügt die Abtastung des analogen Signals 10 während eines beliebig gewählten Zeitabschnitts zu verschiedenen Zeitpunkten, sofern deren zeitliche Lage zueinander bekannt ist. Insbesondere muss die Abtastung während eines solchen Zeitabschnitts nicht in gleichen Zeitabständen erfolgen.

Weiterhin wird zu jedem Abtastzeitpunkt, in welchem ein durch einen Punkt dargestellter Abtastwert ermittelt wird, der zu diesem Zeitpunkt vorliegende zeitliche Gradient des analogen Signals 10 ermittelt, welcher jeweils durch einen Pfeil dargestellt ist. Diese Bestimmung der zeitlichen Gradienten zu den Abtastzeitpunkten ist zweckmäßig, jedoch nicht zwingend erforderlich. Prinzipiell genügt die Bestimmung zeitlicher Gradienten des analogen Signals 10 zu verschiedenen Zeitpunkten.

Figur 2 illustriert den Einfluss der Phasenlage auf den zeitlichen Gradienten in den Abtastpunkten. Während bei der im oberen Graphen dargestellten ungünstigsten Phasenlage die Gradienten in den Abtastzeitpunkten Maximalwerte annehmen, liegt bei der im unteren Graphen dargestellten idealen Phasenlage in den Abtastzeitpunkten stets ein verschwindender zeitlicher Gradient vor. Diese Tatsache kann zur Bestimmung der Phasenlage des Abtasttaktes bezüglich des abzutastenden analogen Signals 10 verwendet werden. Hierfür sind jedoch Kenntnisse über wenigstens einen Teil des zeitlichen Verlaufs des analogen Signals 10 erforderlich. Diese erhält man erfindungsgemäß durch eine näherungsweise Rekonstruktion des Signalverlaufs des analogen Signals 10 in wenigstens einem Teilbereich des durch die abgetasteten Werte und die bestimmten Gradienten vorgegebenen Bereichs, wobei für die Rekonstruktion des Signalverlaufs wenigstens ein Teil der abgetasteten Werte des analogen Signals und wenigstens ein Teil der zeitlichen Gradienten verwendet wird.

Die Rekonstruktion des Signalverlaufs beruht darauf, eine für den analogen Signalverlauf 10 geeignete mathematische Funktion zu wählen und deren Parameter durch Anfitten dieser Funktion an wenigstens einen Teil der Abtastwerte und der zeitlichen Gradienten zu bestimmen. Hierbei kann eine Vielzahl von Funktionen Verwendung finden, beispielsweise trigonometrische Funktionen oder Polynomialfunktionen.

Im vorliegenden Ausführungsbeispiel wurde der näherungsweisen Rekonstruktionen des Signalverlaufs 10 stets ein Polynom vierter Ordnung zu Grunde gelegt. Für die Fittprozedur, also die Bestimmung der fünf Koeffizienten des Polynoms vierter Ordnung, wurde stets die Methode der kleinsten Fehlerquadrate eingesetzt. Selbstverständlich sind darüber hinaus auch andere Algorithmen verwendbar, insbesondere wenn nicht Polynomialfunktionen, sondern andere Funktionen oder Funktionsgruppen der Rekonstruktion des analogen Signalverlaufs 10 zu Grunde gelegt werden.

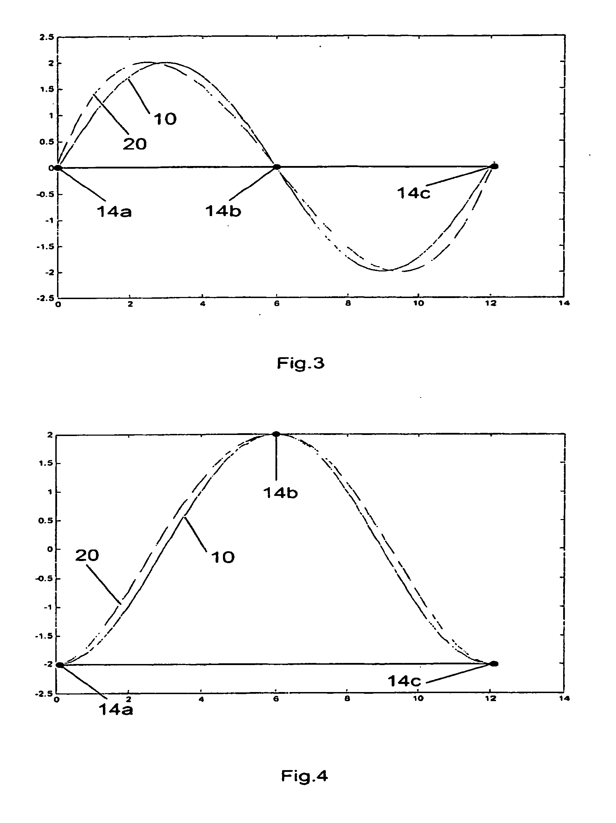

Die Ergebnisse derartiger Rekonstruktionen basierend auf Polynomen vierter Ordnung und der Methode der kleinsten Fehlerquadrate zeigen die Figuren 3 und 4, in welchen sinusoidale Teilbereiche des Signalverlaufs des analogen Signals 10 rekonstruiert wurden. Der Teilbereich, in welchem die Rekonstruktion erfolgte, wurde durch drei Abtastwerte 14a, 14b, 14c bzw. die zugehörigen Abtastzeitpunkte festgelegt. In diesen Punkten wurden weiterhin jeweils die zeitlichen Gradienten bestimmt, welche der Übersichtlichkeit halber nicht gesondert dargestellt sind. Figur 3 zeigt das Ergebnis der Rekonstruktion des Signalverlaufs 10 bei ungünstigster Phasenlage, Figur 4 hingegen bei günstigster Phasenlage des Abtasttaktes. Wie man den Darstellungen entnimmt, gibt der jeweilige näherungsweise rekonstruierte Signalverlauf 20 in beiden Fällen den Signalverlauf des analogen Signals 10 ausreichend genau wieder.

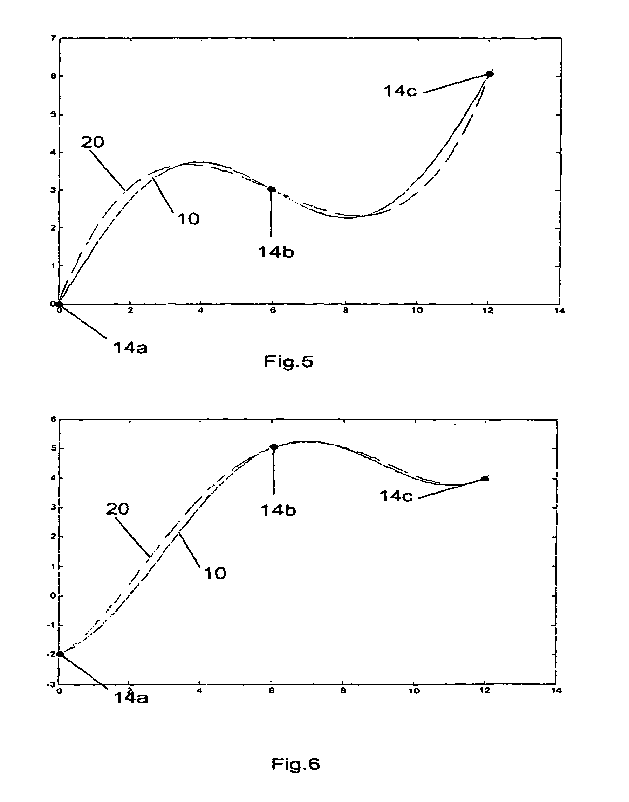

Beispielhaft für nicht sinusoidale Signalverläufe des analogen Signals sind in den Figuren 5 und 6 jeweils Teilbereiche eines analogen Signals 10 dargestellt, die wiederum auf Basis der Abtastwerte 14a, 14b, 14c sowie der in diesen Abtastzeitpunkten vorliegenden zeitlichen Gradienten anhand eines Polynoms vierter Ordnung rekonstruiert wurden. Der näherungsweise rekonstruierte Signalverlauf 20 ist in beiden Figuren gestrichelt dargestellt. In Figur 5 erfolgte die Abtastung bei ungünstigster Phasenlage, in Figur 6 hingegen bei nahezu idealer Phasenlage des Abtasttaktes. Wie man der Figur 5 entnimmt, fallen hier die lokalen Extrema des analogen Signals 10 und des näherungsweise rekonstruierten Signalverlaufs 20 nicht mehr exakt zusammen. Vorteilhafterweise wird jedoch im vorliegenden Ausführungsbeispiel der zeitliche Gradient jeweils in den Abtastpunkten bestimmt, so dass sich mit jedem Regelschritt, bei welchem die Phasenlage in Richtung der idealen Phasenlage verschoben wird, der Bereich der größtmöglichen Übereinstimmung zwischen dem Signalverlauf des analogen Signals 10 und dem näherungsweise rekonstruierten Signalverlauf 20 auf die lokalen Extrempunkte zu verschiebt. Dies wird in Figur 6 ersichtlich, wo die Phasenlage der idealen Phasenlage bereits sehr nahe kommt und in den Extrempunkten eine sehr gute Übereinstimmung zwischen dem analogen Signalverlauf 10 und dem rekonstruierten Signalverlauf 20 vorliegt.

Wie bereits erwähnt wird im vorliegenden Ausführungsbeispiel für die Rekonstruktion des Signalverlaufs ein Polynom vierter Ordnung eingesetzt. Die Bestimmung der fünf Koeffizienten dieses Polynoms erfordert die Lösung eines linearen Gleichungssystems fünfter Ordnung für diese Koeffizienten. Ein solches Gleichungssystem lässt sich bekanntermaßen in Matrixform darstellen. Ein wesentlicher Schritt zur Lösung dieses Gleichungssystems besteht im Weiteren in der Berechnung der inversen Matrix des in Matrixform gebrachten Gleichungssystems fünfter Ordnung. Eine vorteilhafte Weiterbildung der Erfindung sieht nun vor, dass zur näherungsweisen Rekonstruktion des Signalverlaufs stets die gleiche Anzahl von Abtastwerten bzw. zeitlichen Gradienten, welche überdies stets zeitlich in derselben Weise beabstandet sind, herangezogen wird, da auf diese Weise die genannte inverse Matrix nur ein einziges Mal berechnet zu werden braucht und für jeden Rekonstruktionsvorgang verwendet werden kann. Insbesondere können die Koeffizienten der inversen Matrix bereits von vornherein in einem Modul zur Bestimmung der Phasenlage hinterlegt sein, so dass eine Berechnung der inversen Matrix nicht zu erfolgen braucht.

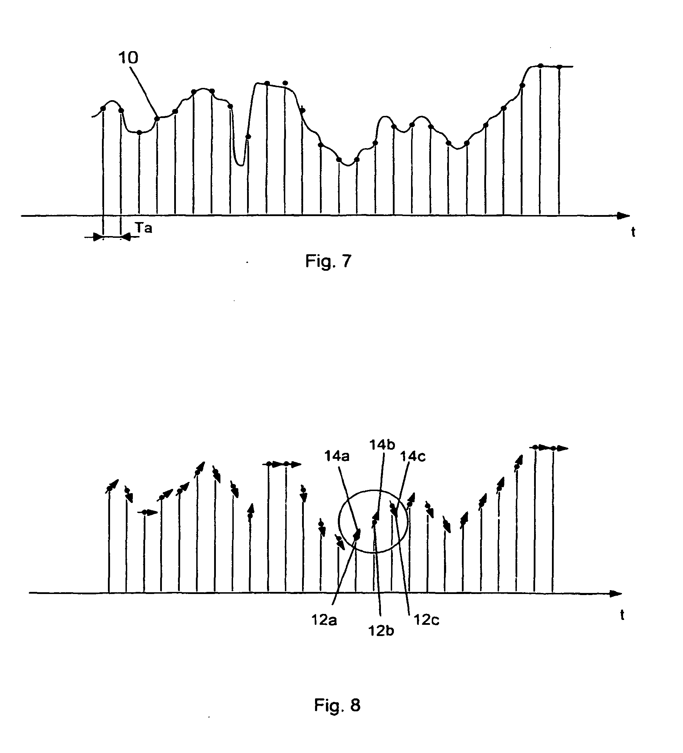

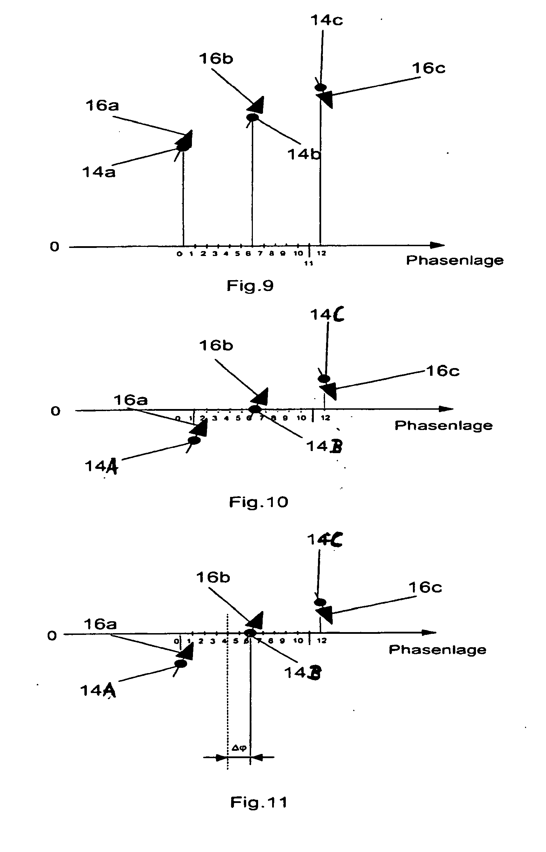

Nachdem vorstehend die näherungsweise Rekonstruktion des Signalverlaufs des analogen Signals 10 näher beschrieben wurde, wird im Folgenden die Bestimmung der Phasenlage sowie deren Regelung näher erläutert. Figur 7 zeigt nochmals einen Teilbereich eines Signalverlaufs eines analogen Signals 10, welches mit dem Abtasttakt Ta abgetastet wird. Beispielsweise wird ein 108 MHz Datensignal mit einer Abtastfrequenz von 108 MHz abgetastet, was einem Abtasttakt Ta und somit einer Periodendauer von 9,25 ns pro Abtastvorgang entspricht. Die zeitlichen Gradienten werden wiederum in den Abtastzeitpunkten bestimmt, so dass sich die in Figur 8 dargestellte Diskretisierung des Signalverlaufs des analogen Signals 10 ergibt, wobei für die Ermittlung der Phasenlage des Abtasttaktes bezüglich des analogen Signals 10 lediglich der markierte Bereich mit den Abtastzeitpunkten 12a, 12b, 12c und den Abtastwerten 14a, 14b, 14c herangezogen wird, welcher in Figur 9 vergrößert dargestellt ist.

Mit der Diskretisierung des Signalverlaufs des analogen Signals 10 wird die Zeitachse bevorzugt nicht mehr als solche interpretiert, sondern als Achse der Phasenlage. Setzt man im vorliegenden Beispiel mit einer Abtastfrequenz von 108 MHz weiterhin beispielhaft voraus, dass der Regelkreis bzw. die Regelschleife zur Regelung der Phasenlage einen Basistakt von 648 MHz besitzt, so folgt, dass pro Abtasttakt Ta sechs Phasenlagen eingestellt werden können. Demzufolge entsprechen zwei Abtasttakte Ta, in welchen im vorliegenden Ausführungsbeispiel drei Abtastwerte 14a, 14b, 14c abgetastet werden, zwölf Phasenlagen, wie sie in Figur 9 auf der Phasenlagenachse abgetragen sind. Alternativ kann die Zeitachse weiterhin als solche betrachtet werden und zu einem späteren Zeitpunkt die Umrechnung einer Zeitinformation in eine Phasenlageninformation erfolgen.

Im Folgenden kann nun, wie oben anhand der Figuren 3 bis 7 näher beschrieben, anhand der Abtastwerte 14a, 14b, 14c und den zugehörigen zeitlichen Gradienten 16a, 16b, 16c der Signalverlauf des analogen Signals 10 rekonstruiert werden.

In einer bevorzugten Weiterbildung wird jedoch zunächst eine Transformation der Abtastwerte durchgeführt. Hierbei werden die abgetasteten Werte des analogen Signals 10 in einen gewünschten Wertebereich überführt. Dies ermöglicht eine einfachere und genauere Berechnung des näherungsweise rekonstruierten Signalverlaufs sowie der Phasenlage. Im vorliegenden Ausführungsbeispiel erfolgt diese Transformation durch Addition des negativen Wertes des Medianwertes der Abtastwerte, in Figur 9 also des negativen Abtastwertes 14b, zu allen Abtastwerten 14a, 14b, 14c, die sich im für die Rekonstruktion des Signalverlaufs herangezogenen Teilbereich des analogen Signals 10 befinden. Infolge dessen erhält man drei neue Abtastwerte 14A, 14B, 14C, wobei der mittlere Abtastwert 14B in Figur 10 auf der Phasenlageachse zu liegen kommt.

Mit der nun folgenden näherungsweisen Rekonstruktion des Signalverlaufs des analogen Signals 10 liegt nicht nur dieser rekonstruierte Signalverlauf, sondern auch dessen zeitliche Ableitung vor. Wie im Zusammenhang mit Figur 2 erläutert wurde, fallen bei einer idealen Phasenlage des Abtasttaktes bezüglich des abzutastenden analogen Signals 10 die Abtastpunkte bzw. die Abtastzeitpunkte in lokale Extrema des Signalverlaufs des analogen Signals 10, in welchen der zeitliche Gradient des Signalverlaufs des analogen Signals 10 verschwindet. Demzufolge stellt der Abstand eines Abtastpunktes bzw. Abtastwertes 14A, 14B, 14C auf der Phasenlagenachse von der ihm nächstgelegenen Nullstelle der zeitlichen Ableitung des rekonstruierten Signalverlaufs die Phasendifferenz Δϕ der Phasenlage des Abtasttaktes von der idealen Phasenlage dar. Es ist daher somit zunächst die einem Abtastwert bzw. -zeitpunkt nächstgelegene Nullstelle der ersten zeitlichen Ableitung des rekonstruierten Signalverlaufs zu ermitteln und sodann deren Abstand auf der Phasenlagenachse von dem genannten Abtastzeitpunkt zu bestimmen, welcher die gesuchte Phasendifferenz Δϕ der Phasenlage des Abtasttaktes von der idealen Phasenlage darstellt. Ist nicht wie oben beschrieben eine Uminterpretation der Zeitachse in eine Phasenlagenachse erfolgt, so wäre an dieser Stelle der zeitliche Abstand der ermittelten, einem Abtastwert bzw. Abtastzeitpunkt nächstgelegenen Nullstelle von diesem Abtastzeitpunkt zu bestimmen und dieser in die Phasendifferenz Δϕ der Phasenlage des Abtasttaktes von der idealen Phasenlage umzurechnen.

Im vorliegenden Ausführungsbeispiel wird die dem mittleren Abtastwert 14B nächstgelegene Nullstelle der ersten zeitlichen Ableitung des Signalverlaufs des analogen Signals 10 bestimmt. Dies ist von Vorteil, da im Falle der Betrachtung des Abtastwertes 14A oder des Wertes 14C die nächstgelegene Nullstelle der zeitlichen Ableitung außerhalb des betrachteten Wertebereichs liegen könnte, was zu Phasensprüngen in der Regelung der Phasenlage führen könnte und diese gegebenenfalls instabil werden ließe. Vorzugsweise sollte daher die nächstgelegene Nullstelle eines solchen Abtastwertes bestimmt werden, welcher zeitlich zwischen zwei weiteren Abtastzeitpunkten liegt, die ihrerseits Teil des für die näherungsweise Rekonstruktion des Signalverlaufs des analogen Signals 10 herangezogenen Teilbereichs des analogen Signals 10 sind.

Für die Bestimmung der dem Abtastwert 14B bzw. dem zugehörigen Abtastzeitpunkt 12b nächstgelegenen Nullstelle der ersten zeitlichen Ableitung des Signalverlaufs des analogen Signals 10 wird vorzugsweise das an sich bekannte Newton-Horner-Schema eingesetzt, wobei als Startwert für die Nullstellen-Suche bevorzugt der Abtastzeitpunkt 12b des betrachteten Abtastwertes 14B herangezogen wird. Das Newton-Horner-Schema hat die Eigenschaft, dass es zu der dem Startwert nächstgelegenen Nullstelle konvergiert.

Im Folgenden wird aus dem zeitlichen Abstand der ermittelten Nullstelle vom gewählten Abtastwert 14B bzw. des zugehörigen Abtastzeitpunktes 12b die Phasenlage des Abtasttaktes bezüglich des analogen Signals bzw. die Phasendifferenz des Abtasttaktes zur idealen Phasenlage ermittelt und einem Regelkreis bzw. einer Regelschleife zugeführt, welche die Phasenlage derart nachregelt, dass der Abtastzeitpunkt 12b mit der zeitlichen Lage der bestimmten Nullstelle möglichst zusammenfällt. Dabei ist zu bemerken, dass auf Grund der beschränkten Anzahl einstellbarer Phasenlagen, im vorliegenden Beispiel eines Basistaktes von 648 MHz sechs Phasenlagen, das Einstellen einer idealen Phasenlage nicht in jedem Falle möglich ist, da diese gegebenenfalls nicht exakt einer der einstellbaren sechs Phasenlagen entspricht. In diesem Fall bewirkt die Regelschleife eine Einstellung derjenigen Phasenlage, welche der idealen Phasenlage am nächsten kommt.

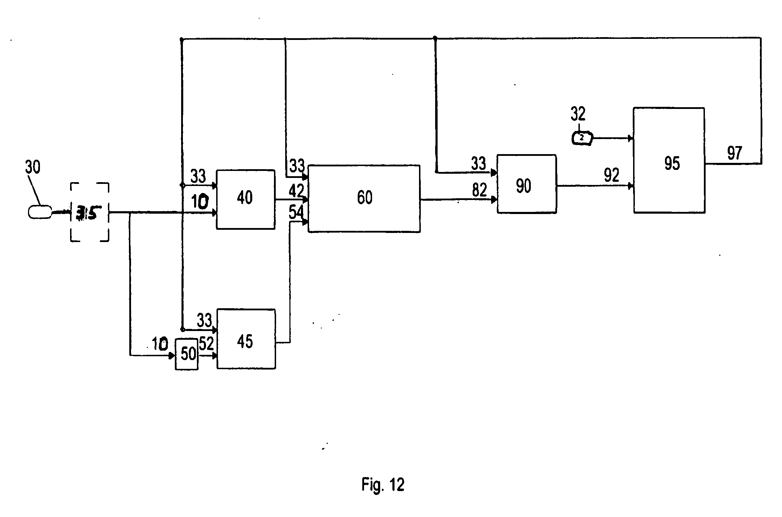

Figur 12 zeigt eine erfindungsgemäße Vorrichtung zur Rekonstruktion und Regelung der Phasenlage eines Abtasttaktes bezüglich eines abzutastenden analogen Signals. Darin ist mit 30 ein analoger Signaleingang bezeichnet, von welchem aus das analoge Signal 10 zu einem an einen ersten AD-Wandler 40, zum anderen an eine zeitliche Differenziereinheit 50 herangeführt ist. Die Vorrichtung umfasst weiterhin ein Taktgeber 32, welcher ein Taktsignal liefert, welches, gegebenenfalls modifiziert durch einen Phasenregelkreis, dem ersten AD-Wandler 40, einem zweiten AD-Wandler 45 und einem Modul zur Bestimmung der Phasenlage 60 zuführbar ist.

Mit dem ersten AD-Wandler 40 ist das analoge Signal 10 auf Basis des Taktsignals 33 zu verschiedenen Zeitpunkten abtastbar. Die resultierenden Abtastwerte 42 des analogen Signals 10 sind dem Modul zur Bestimmung der Phasenlage 60 zuführbar. Nach zeitlicher Differentiation des analogen Signals 10 in der zeitlichen Differenziereinheit 50 kann das zeitlich differenzierte analoge Signal 52 zusammen mit dem Taktsignal 33 dem zweiten AD-Wandler 45 zugeführt werden. Auf Grund der Kopplung mit dem Taktsignal 33 kann dieser zweite AD-Wandler 45 das zeitlich differenzierte analoge Signal 52 zu denselben Zeitpunkten abtasten wie der erste AD-Wandler 40 das analoge Signal 10, so dass zu jedem zu einem gewissen Zeitpunkt abgetasteten Wert des analogen Signals 10 der zu diesem Zeitpunkt gehörige Wert des zeitlich differenzierten Signals 52 abgetastet werden kann. Wie bereits weiter oben ausgeführt wurde, ist dies zwar nicht zwingend erforderlich, stellt aber eine vorteilhafte Ausführungsform der Erfindung dar.

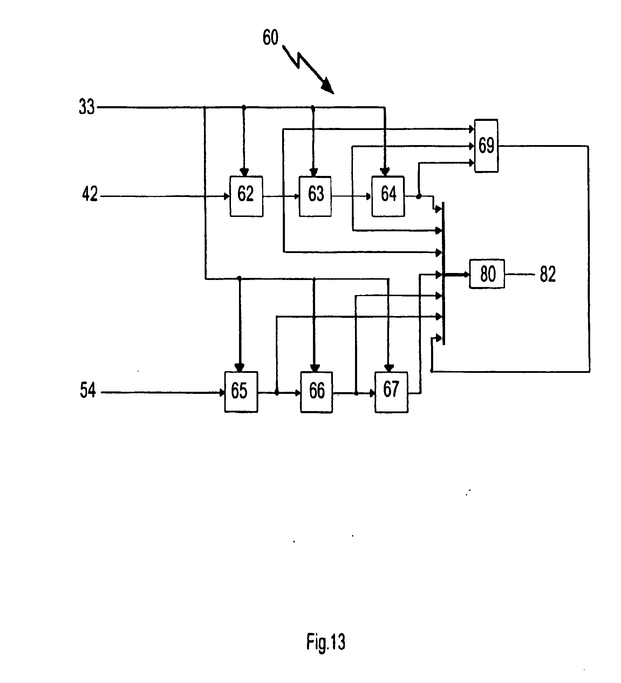

Nach Abtastung des zeitlich differenzierten analogen Signals 52 stellt der zweite AD-Wandler 45 dem Modul zur Bestimmung der Phasenlage 60 die zeitlichen Gradienten des analogen Signals 54 zu den Abtastzeitpunkten zur Verfügung. Im Modul zur Bestimmung der Phasenlage 60 selbst, welches anhand Figur 13 näher erläutert werden wird, ist die Phasenlage bzw. die Phasendifferenz gegenüber der Idealphase des Abtasttaktes bezüglich des Signalverlaufs des analogen Signals 10 bestimmbar. Die berechnete Phasenlage bzw. Phasendifferenz gegenüber der Idealphase 82 wird im vorliegenden Ausführungsbeispiel einem Proportional-Integral-Regler 90 (PI-Regler) zugeführt, an welchem überdies das Taktsignal 33 anliegt. Mit diesem ist die Phaseninformation 92 für den Regelkreis bzw. die Regelschleife berechenbar, welche hier als Verzögerungsregelkreis (delay locked loop - DLL) 95 ausgeführt ist. Der genannte PI-Regler stellt eine vorteilhafte Weiterbildung der Erfindung dar, da er das Systemverhalten bei Phasenrauschen und bei Phasensprüngen verbessert, jedoch ist er nicht zwingend erforderlich.

Mit dem Regelkreis bzw. der DLL 95 ist auf Basis der Phaseninformation 92 der Takt des Taktgebers 32 so veränderbar, dass dieser einen verschobenen Takt 97 ausgibt, welcher wiederum als neues Taktsignal 33 den anderen Bauteilen zugeführt werden kann, wodurch eine iterative Regelung der Phasenlage des Abtasttaktes bezüglich des abzutastenden analogen Signals 10 realisierbar ist.

In Figur 13 ist ein Ausführungsbeispiel des Moduls zur Bestimmung der Phasenlage 60 aus Figur 12 dargestellt. Hierin kann ein Teilbereich des durch die abgetasteten Werte 42 des analogen Signals 10 und durch die zeitlichen Gradienten des analogen Signals 54 vorgegebenen Bereichs des Signalverlaufs des analogen Signals 10 zur näherungsweisen Rekonstruktion des Signalverlaufs herangezogen werden, wobei wenigstens ein Teil der abgetasteten Werte 42 des analogen Signals 10 und wenigstens ein Teil der zeitlichen Gradienten des analogen Signals 54 Verwendung finden.

In der dargestellten Ausgestaltungsvariante der Erfindung ist für jeden zur Rekonstruktion des Signalverlaufs herangezogenen Abtastwert des analogen Signals 42 ein Speicherregister 62, 63, 64 und für jeden zur Rekonstruktion des Signalverlaufs herangezogenen zeitlichen Gradienten des analogen Signals 54 je ein Speicherregister 65, 66, 67 vorgesehen. Prinzipiell kann selbstverständlich die Rekonstruktion des Signalverlaufs auf Basis von mehr als drei Abtastwerten des analogen Signals 42 und mehr als drei zeitlichen Gradienten des analogen Signals 54 erfolgen, wobei gegebenenfalls eine entsprechende Zahl an Speicherregistern vorgesehen werden kann.

Die Speicherregister 62, 63, 64 sind im dargestellten Ausführungsbeispiel mit zu unterschiedlichen Zeitpunkten abgetasteten Abtastwerten des analogen Signals 42 belegbar. In den Registern 65, 66, 67 hingegen können die zu verschiedenen Zeitpunkten bestimmten zeitlichen Gradienten des analogen Signals 54 gespeichert werden. Im Weiteren sind die Inhalte der Register 62, 63, 64, 65, 66, 67 einem Microcontroller 80 zuführbar, in welchem die abschnittsweise Rekonstruktion des Signalverlaufs des analogen Signals 10 erfolgen kann. Ferner kann dort die einem Abtastzeitpunkt nächstgelegene Nullstelle der ersten zeitlichen Ableitung des Rekonstruierten Signalverlaufs bestimmt und, wie oben näher beschrieben, die Phasenlage des Abtasttaktes bezüglich des analogen Signals 10 aus dem zeitlichen Abstand dieses Abtastzeitpunktes von der zeitlichen Lage der bestimmten Nullstelle, bzw. bei Verwendung einer Phasenlagenachse aus dem Abstand auf der Phasenlagenachse des Abtastzeitpunktes bzw. -wertes von der ermittelten Nullstelle, ermittelt werden. Die so berechnete Phasenlage bzw. Phasendifferenz gegenüber der Idealphase 82 des Abtasttaktes kann letztlich vom Modul zur Bestimmung der Phasenlage 60 ausgegeben werden.

Ein vorteilhafte Weiterbildung der Erfindung sieht ferner die Integration eines Medianoperators 69 vor, mit dessen Hilfe die in den Registern 62, 63, 64 abgelegten Abtastwerte des analogen Signals 42 auf den mittleren dieser Werte bezogen werden können, wodurch eine Transformation der Abtastwerte des analogen Signals 42 in die Umgebung des Nullwertes bewirkt wird. Dies ermöglicht eine genauere Berechnung des rekonstruierten Signalverlaufs.

Es ist nicht erforderlich, der erfindungsgemäßen Vorrichtung fortlaufend Daten zur Berechnung der Phasenlage zuzuführen. In der Regel genügt es, wenn dem Microcontroller nach Beendigung einer Berechnung die Werte für die nächste Berechnung zur Verfügung gestellt werden. Da eine Phasenänderung im allgemeinen sehr langsam und eher selten auftritt, besteht darüber hinaus die Möglichkeit, sich lediglich gezielt auf einzelne Rekonstruktionsvorgänge der Phasenlage und entsprechende Regelungsvorgänge zu beschränken, beispielsweise ein Vorgang in der Mitte einer Zeile eines Videosignals. In diesen Fällen stünde für die Berechnung vergleichsweise viel Zeit zur Verfügung.

Eine unterbrechungsfreie Auswertung der Abtastwerte 42 bzw. der zeitlichen Gradienten 54 ist demnach nicht erforderlich. Die Berechnung der Phasenlage des Abtasttaktes bezüglich des Signalverlaufs des analogen Signals 10 kann zu jedem beliebigen Zeitpunkt durchgeführt werden. Dies ist insbesondere dann interessant, wenn Hardware bzw. Bauelemente eingespart werden sollen.

Ist die Frequenz des Datensignals bekannt und das Signal durch Störungen und/oder Rauschen mit Frequenzen größer als diese Datensignalfrequenz beeinträchtigt, so sieht eine Weiterbildung der Erfindung vor, Anteile des analogen Signals 10 mit Frequenzen größer als die Datensignalfrequenz herauszufiltern und nicht in die Bestimmung und Regelung der Phasenlage einfließen zu lassen. In Bezug auf eine erfindungsgemäße Vorrichtung kann dies insbesondere durch die Integration eines optionalen Tiefpassfilters 35 realisiert werden. Auf diese Weise wird eine schnellere Einstellung der möglichst idealen Phasenlage des Abtasttaktes ermöglicht, da vorläufige Fehlregelungen in Richtung lokaler Extrema hochfrequenter Störungen vermieden wird. Ist die Frequenz des Datensignals in Grenzen variabel, so kann die maximal vorkommende Frequenz als Grenzfrequenz für den Tiefpassfilter oder dergleichen verwendet werden.

Abschließend sei bemerkt, dass in denjenigen Fällen, in denen ein exakt rekonstruierter Signalverlauf des analogen Signals 10 von geringerer Bedeutung ist, auch "vereinfachte Gradienten" zum Einsatz kommen können, die lediglich eine Information darüber liefern, ob der Signalverlauf zum Abtastzeitpunkt steigt, fällt oder gleichbleibend ist. Dies ist gleichbedeutend mit einem Wertbereich dieser vereinfachten Gradienten von -1, 0 und 1 oder entsprechenden Bezeichnungen. Da ein im Betrag falscher Gradientenwert jedoch nur Einfluss auf die Amplitude hat, ist diese Information ausreichend für die Bestimmung bzw. die Regelung der Phasenlage des Abtasttaktes bezüglich eines abzutastenden analogen Signals 10.

### Bezugszeichenliste

- 10: analoger Signal
- 12: Abtastzeitpunkt
- 12a: Abtastzeitpunkt
- 12b: Abtastzeitpunkt
- 12c: Abtastzeitpunkt
- 14: Abtastwert
- 14A: Abtastwert
- 14B: Abtastwert
- 14C: Abtastwert
- 14a: Abtastwert
- 14b: Abtastwert
- 14c: Abtastwert
- 16a: zeitlicher Gradient
- 16b: zeitlicher Gradient
- 16c: zeitlicher Gradient
- 20: näherungsweise rekonstruierter Signalverlauf
- 30: Eingang analoges Signal
- 32: Taktgeber
- 33: Taktsignal
- 35: optionaler Tiefpassfilter
- 40: AD-Wandler 1
- 42: Abtastwerte des analogen Signals
- 45: AD-Wandler 2
- 50: zeitliche Differenziereinheit
- 52: zeitlich differenziertes analoges Signal
- 54: zeitliche Gradienten des analogen Signals
- 60: Modul zur Bestimmung der Phasenlage
- 62: Register 1
- 63: Register 2
- 64: Register 3
- 65: Register 4
- 66: Register 5
- 67: Register 6
- 69: Medianoperator
- 80: Microcontroller
- 82: berechnete Phasenlage bzw. -differenz gegenüber Idealphase
- 90: PI-Regler
- 92: Phaseninformation für DLL
- 95: DLL
- 97: verschobener Takt

- Ta: Abtasttakt
- W1: Signalwert 1
- W2: Signalwert 2
- E: nicht zuordenbare Abtastergebnisse
- E1: W1 zuordenbare Abtastergebnisse
- E2: W2 zuordenbare Abtastergebnisse
- D: Trennung der Abtastergebnisse
- Δϕ: Phasendifferenz gegenüber Idealphase

## Patentansprüche

1. Verfahren zur Rekonstruktion und Regelung der Phasenlage eines Abtasttaktes (Ta) bezüglich eines abzutastenden analogen Signals (10) bestehend aus
1.1 dem Abtasten von Werten (42) des analogen Signals (10) mit dem Abtasttakt (Ta) zu verschiedenen Zeitpunkten,
1.2 der Bestimmung der zeitlichen Gradienten (54) des analogen Signals zu verschiedenen Zeitpunkten,
1.3 der näherungsweisen Rekonstruktion des Signalsverlaufs des analogen Signals (10) in wenigstens einem Teilbereich des durch die abgetasteten Werte (42) und die bestimmten Gradienten (54) vorgegebenen Bereichs unter Verwendung wenigstens eines Teils der abgetasteten Werte (14a, 14b, 14c) des analogen Signals (10) und eines Teils der bestimmten zeitlichen Gradienten (16a, 16b, 16c),
1.4 der Bestimmung einer einem Abtastzeitpunkt (12b) nächstgelegenen Nullstelle der ersten zeitlichen Ableitung des rekonstruierten Signalverlaufs,
1.5 der Ermittlung der Phasenlage (Δϕ) des Abtasttaktes (Ta) bezüglich des analogen Signals (10) aus dem zeitlichen Abstand dieses Abtastzeitpunktes (12b) von der zeitlichen Lage der bestimmten Nullstelle,
1.6 der Zuführung der ermittelten Phasenlage (Δϕ) in eine Regelschleife (95, 90), welche die Phasenlage (Δϕ) derart nachregelt, dass dieser Abtastzeitpunkt (12b) mit der zeitlichen Lage der bestimmten Nullstelle möglichst zusammenfällt.

2. Verfahren nach Anspruch 1,
**dadurch gekennzeichnet, dass** die Gradienten des analogen Signals (45) in denjenigen Zeitpunkten bestimmt werden, in denen die Werte des analogen Signals (42) abgetastet werden.

3. Verfahren nach einem der Ansprüche 1 bis 2,
**dadurch gekennzeichnet, dass** mindestens drei Werte (14a, 14b 14c) des analogen Signals (10) abgetastet und in mindestens drei Zeitpunkten (12a, 12b, 12c) die zeitlichen Gradienten (16a, 16b, 16c) des analogen Signals (10) bestimmt werden.

4. Verfahren nach Anspruch 2,
**dadurch gekennzeichnet, dass** zur näherungsweise Rekonstruktion des Signalverlaufs des analogen Signals (10) drei Datenpaare bestehend aus je einem Abtastwert (14a, 14b, 14c) und dem zugehörigen zeitlichen Gradienten (16a, 16b, 16c) zum Abtastzeitpunkt (12a, 12b, 12c) des jeweiligen Abtastwertes (14a, 14b, 14c) herangezogen werden.

5. Verfahren nach einem der Ansprüche 3 oder 4,
**dadurch gekennzeichnet, dass** derjenige Abtastzeitpunkt (12b), dessen nächstgelegene Nullstelle der ersten zeitlichen Ableitung des näherungsweise rekonstruierten Signalverlaufs bestimmt wird, zeitlich zwischen zwei weiteren Abtastzeitpunkten (12a, 12c) liegt.

6. Verfahren nach einem der Ansprüche 1 bis 5,
**dadurch gekennzeichnet, dass** zur näherungsweisen Rekonstruktion des Signalverlaufs des analogen Signals (10) ein Polynom, insbesondere ein Polynom vierter Ordnung verwendet wird.

7. Verfahren nach Anspruch 6,
**dadurch gekennzeichnet, dass** zur Bestimmung geeigneter Koeffizienten des Polynoms die Methode der kleinsten Fehlerquadrate angewandt wird.

8. Verfahren nach einem der Ansprüche 1 bis 7,
**dadurch gekennzeichnet, dass** der für die Rekonstruktion des Signalverlaufs des analogen Signals (10) herangezogene Wertebereich der abgetasteten Werte (14a, 14b, 14c) des analogen Signals (10) durch eine Transformation in einen gewünschten Wertebereich überführt wird, insbesondere durch Addition eines einheitlichen Wertes zu allen im herangezogenen Wertebereich liegenden Abtastwerten (14a, 14b, 14c).

9. Verfahren nach einem der Ansprüche 1 bis 8,
**dadurch gekennzeichnet, dass** für die Bestimmung der einem Abtastzeitpunkt (14B) nächstgelegenen Nullstelle das Newton-Horner-Schema eingesetzt wird.

10. Vorrichtung zur Rekonstruktion und Regelung der Phasenlage (82) eines Abtasttaktes (Ta) bezüglich eines abzutastenden analogen Signals (10) umfassend
10.1 einen Taktgeber (32) zur Erzeugung eines den Abtasttakt (Ta) bildenden Taktsignals (33),
10.2 mindestens einen mit dem Taktgeber (32) gekoppelten AD-Wandler (40) zum Abtasten von Werten (42) des analogen Signals (10) zu verschiedenen Zeitpunkten, 10.3 eine Einrichtung zur einfachen zeitlichen Differentiation des analogen Signals (50),
10.4 mindestens einen mit dem Taktgeber (32) gekoppelten AD-Wandler (45) zum Abtasten des zeitlich differenzierten analogen Signals (52) zu verschiedenen Zeitpunkten,
10.5 ein Modul zur Bestimmung der Phasenlage (60) durch
10.5.1 näherungsweise Rekonstruktion des Signalverlaufs des analogen Signals (10) in wenigstens einem Teilbereich des durch die abgetasteten Werte (42, 54) des analogen Signals (10) und des differenzierten analogen Signals (52) vorgegebenen Bereichs des analogen Signals (10) unter Verwendung wenigstens eines Teils der abgetasteten Werte des analogen Signals (42) und wenigstens eines Teils der abgetasteten Werte des zeitlich differenzierten analogen Signals (54),
10.5.2 die Bestimmung einer einem Abtastzeitpunkt (12b) nächstgelegenen Nullstelle der ersten zeitlichen Ableitung des näherungsweisen rekonstruierten Signalverlaufs,
10.5.3 die Ermittlung der Phasenlage (82) des Abtasttaktes (Ta) bezüglich des analogen Signals (10) aus dem zeitlichen Abstand dieses Abtastzeitpunktes (12b) von der zeitlichen Lage der bestimmten Nullstelle,
10.6 einen Regelkreis (95, 90) zur Nachführung der Phasenlage (82) des Abtasttaktes (Ta) bezüglich des analogen Signals (10) anhand der im Modul zur Bestimmung der Phasenlage (60) bestimmten Phasenlage (82).

11. Vorrichtung nach Anspruch 10,
**dadurch gekennzeichnet, dass** die AD-Wandler (40, 45) derart mit dem Taktgeber (32) gekoppelt sind, dass zu jedem zu einem gewissen Zeitpunkt abgetasteten Wert (42) des analogen Signals (10) der zu diesem Zeitpunkt gehörige Wert (54) des zeitlich differenzierten Signals (52) abtastbar ist.

12. Vorrichtung nach einem der Ansprüche 10 bis 11,
**dadurch gekennzeichnet, dass** für jeden zur näherungsweisen Rekonstruktion des Signalverlaufs des analogen Signals (10) verwendeten abgetasteten Wert (42) des analogen Signals (10) je ein Speicherregister (62, 63, 64) und für jeden zu dieser Rekonstruktion abgetasteten Wert (54) des zeitlich differenzierten analogen Signals (52) ebenfalls je ein Speicherregister (65, 66, 67) vorgesehen ist, insbesondere jeweils drei Speicherregister.

13. Vorrichtung nach einem der Ansprüche 10 bis 12,
**dadurch gekennzeichnet, dass** das Modul zur Bestimmung der Phasenlage (60) einen Medianoperator (69) umfasst.

14. Vorrichtung nach einem der Ansprüche 10 bis 13,
**dadurch gekennzeichnet, dass** das Modul zur Bestimmung der Phasenlage (60) einen Microcontroller (80) umfasst.

15. Vorrichtung nach einem der Ansprüche 10 bis 14,
**dadurch gekennzeichnet, dass** der Regelkreis zur Nachführung der Phasenlage (95, 90) einen Verzögerungsregelkreis (delay locked loop - DLL) (95) umfasst.

16. Vorrichtung nach einem der Ansprüche 10 bis 15,
**dadurch gekennzeichnet, dass** der Regelkreis zur Nachführung der Phasenlage (95, 90) ein Regelelement (90), insbesondere einen Proportional-Integral-Regler (PI-Regler) umfasst.

## Claims

1. Method for reconstruction and regulation of the phase position of a scanning frequency (Ta) with respect to an analog signal (10) to be scanned, consisting of:
1.1 scanning of values (42) of the analog signal (10) at the scanning frequency (Ta) at different time instants,
1.2 determining the gradients (54) over time of the analog signal at different time instants,
1.3 approximate reconstructing of the signal course of the analog signal (10) in at least one subregion of the region, which is predetermined by the scanned values (42) and the determined gradients (54), with use of at least a part of the scanned values (14a, 14b, 14c) of the analog signal (10) and a part of the determined time gradients (16a, 16b, 16c),
1.4 determining a zero position, which is closest to scanning time instant (12b), of the first time derivative of the reconstructed course,
1.5 ascertaining the phase position (Δϕ) of the scanning frequency (Ta) with respect to the analog signal (10) from the time spacing of this scanning time instant (12b) from the time position of the determined zero position and
1.6 feeding the ascertained phase position (Δϕ) into a regulating loop (95, 90) which so regulates the phase position (Δϕ) that this scanning time instant (12b) coincides as far as possible with the time position of the determined zero position.

2. Method according to claim 1, **characterised in that** the gradients of the analog signal (45) are determined at those time instants at which the values of the analog signal (42) are scanned.

3. Method according one of claims 1 and 2, **characterised in that** at least three values (14a, 14b, 14c) of the analog signal (10) are scanned and the time gradients (16a, 16b, 16c) of the analog signal (10) are determined at at least three time instants (12a, 12b, 12c).

4. Method according to claim 2, **characterised in that** three data pairs each consisting of a respective scanning value (14a, 14b, 14c) and the associated time gradient (16a, 16b, 16c) at the scanning time instant (12a, 12b, 12c) of the respective scanning value (14a, 14b, 14c) are utilised for the approximate reconstruction of the signal course of the analog signal (10).

5. Method according to one of claims 3 and 4, **characterised in that** that scanning time instant (12) of which the nearest zero position of the first time derivative of the approximately reconstructed signal course is determined lies in time between two further scanning time instants (12a, 12c).

6. Method according to any one of claims 1 to 5, **characterised in that** a polynomial, particularly a polynomial of fourth order, is used for the approximate reconstruction of the signal course of the analog signal (10).

7. Method according to claim 6, **characterised in that** the method of smallest error squares is used for the determination of suitable coefficients of the polynomial.

8. Method according to any one of claims 1 to 7, **characterised in that** the values range, which is utilised for the reconstruction of the signal course of the analog signal (10), of the scanned values (14a, 14b, 14c) of the analog signal (10) is transferred by a transformation into a desired values range, particularly by addition of a unitary value to all scanning values (14a, 14b, 14c) lying in the utilised values range.

9. Method according to any one of claims 1 to 8, **characterised in that** the Newton-Horner method is used for determination of the zero position nearest to the scanning time instant (14B).

10. Device for reconstruction and regulation of the phase position (82) of a scanning frequency (Ta) with respect to an analog signal (10) to be scanned, comprising
10.1 a frequency transmitter (32) for generating a clock signal (33) forming the scanning frequency (Ta),
10.2 at least one analog-to-digital converter (40), which is coupled with the frequency transmitter (32), for the scanning of values (42) of the analog signal (10) at different time instants,
10.3 a device for simple time differentiation of the analog signal (50),
10.4 at least one analog-to-digital converter (45), which is coupled with the frequency transmitter (32), for scanning the analog signal (52), which is differentiated over time, at different time instants,
10.5 a module for determining the phase position (60) by
10.5.1 approximate reconstruction of the signal course of the analog signal (10) in at least one subregion of the region, which is predetermined by the scanned values (42, 54) of the analog signal (10) and the differentiated analog signal (52), of the analog signal (10) with use of at least part of the scanned values of the analog signal (42) and at least a part of the scanned values of the analog signal (54) differentiated over time,
10.5.2 determination of a zero position, which is closest to a scanning time instant (12b), of the first time derivative of the approximately reconstructed signal course,
10.5.3 ascertaining of the phase position (82) of the scanning frequency (Ta) with respect to the analog signal (10) from the spacing in time of this scanning time instant (12b) from the position in time of the determined zero position,
10.6 a regulating circuit (95, 90) for adjusting the phase position (82) of the scanning frequency (Ta) with respect to the analog signal (10) on the basis of the phase position (82) determined in the module for determination of the phase position (60).

11. Device according to claim 10, **characterised in that** the analog-to-digital converter (40, 45) is so coupled with the frequency transmitter (32) that for each value (42), which is scanned at a specific time instant, of the analog signal (10) the value (54), which belongs to this time instant, of the signal (52) differentiated with respect to time is scannable.

12. Device according to one of claims 10 and 11, **characterised in that** a respective storage register (62, 63, 64) is provided for each scanned value (42), which is used for the approximate reconstruction of the signal course of the analog signal (10), of the analog signal (10) and similarly a respective storage register (65, 66, 67) is provided for each value (54), which is scanned for this reconstruction, of the analog signal (52) differentiated over time, particularly in each instance three storage registers.

13. Device according to any one of claims 10 to 12, **characterised in that** the module for determination of the phase position (60) comprises a median operator (69).

14. Device according to any one of claims 10 to 13, **characterised in that** the module for determination of the phase position (60) comprises a microcontroller (80).

15. Device according to any one of claims 10 to 14, **characterised in that** the regulating circuit for adjusting the phase position (95, 90) comprises a delay regulating circuit (delay locked loop - DLL) (95).

16. Device according to any one of claims 10 to 15, **characterised in that** the regulating circuit for adjusting the phase position (95, 90) comprises a regulating element (90), particularly a proportional-integral regulator (PI regulator).

## Revendications

1. Procédé de reconstruction et de régulation de la position de phase d'une horloge d'échantillonnage (Ta) pour un signal (10) analogique sous balayage, comprenant :
1.1 la scrutation de valeurs (42) du signal analogique (10) avec l'horloge d'échantillonnage (Ta), à différents moments,
1.2 la détermination des gradients temporels (54) du signal analogique à différents moments,
1.3 la reconstruction, par approximations, de la forme du signal analogique (10) sur au moins une plage partielle de la plage prédéterminée par les valeurs (42) scrutées et les gradients (54) déterminés, en utilisant au moins une partie des valeurs (14a, 14b, 14c) scrutées du signal analogique (10) et une partie des gradients (16a, 16b, 16c) temporels déterminés,
1.4 la détermination d'un point zéro, le plus proche possible d'un moment de scrutation (12b), de la première dérivée en fonction du temps de la forme du signal reconstruite,
1.5 la détermination de la position de phase (Δϕ) de l'horloge d'échantillonnage (Ta) concernant le signal analogique (10), à partir de l'espacement temporel entre ce moment de scrutation (12b) et la position temporelle du point zéro déterminé,
1.6 l'amenée de la position de phase (Δϕ) déterminée dans une boucle de régulation (95, 90), opérant le rattrapage de la position de phase (Δϕ), de manière à ce que ce moment de scrutation (12b) coïncide autant que possible avec la position temporelle du point zéro déterminé.

2. Procédé selon la revendication 1, **caractérisé en ce que** les gradients du signal analogique (45) sont déterminés aux moments auxquels les valeurs du signal analogique (42) sont scrutées.

3. Procédé selon l'une des revendications 1 à 2, **caractérisé en ce qu'**au moins trois valeurs (14a, 14b, 14c) du signal analogique (10) sont scrutées, et les gradients temporels (16a, 16b, 16c) du signal analogique (10) sont déterminés en au moins trois moments (12a, 12b, 12c).

4. Procédé selon la revendication 2, **caractérisé en ce que** trois paires de données, composées chacune d'une valeur de scrutation (14a, 14b, 14c) et du gradient temporel (16a, 16b, 16c) afférent, au moment de scrutation (12a, 12b, 12c) de la valeur de scrutation (14a, 14b, 14c) respective, sont utilisées pour la reconstruction par approximation de la forme du signal analogique (10).

5. Procédé selon l'une des revendications 3 ou 4, **caractérisé en ce que** le moment déterminé de scrutation (12b), dont le point zéro, le plus proche possible, de la première dérivée en fonction du temps de la forme du signal reconstruite par approximation, est situé temporellement entre deux autres moments de scrutation (12a, 12c).

6. Procédé selon l'une des revendications 1 à 5, **caractérisé en ce qu'**un polynôme, en particulier un polynôme de quatrième ordre, est utilisé pour la reconstruction par approximations de la forme du signal.

7. Procédé selon la revendication 6, **caractérisé en ce que** la méthode standard des moindres carrés est utilisée pour la détermination de coefficients appropriés du polynome.

8. Procédé selon l'une des revendications 1 à 7, **caractérisé en ce que** la plage de valeurs, sollicitée pour la reconstruction de la forme du signal analogique (10), des valeurs (14a, 14b, 14c) scrutées du signal analogique (10) est transformée en une plage de valeurs souhaitée au moyen d'une transformation, en particulier par addition d'une valeur unitaire à toutes les valeurs de scrutation (14a, 14b, 14c) situées sur la plage de valeur sollicitée.

9. Procédé selon l'une des revendications 1 à 8, **caractérisé en ce que** le schéma Newton-Horner est utilisé pour la détermination du point zéro le plus proche d'un point de scrutation (14B).

10. Dispositif de reconstruction et de régulation de la position de phase (82) d'une horloge d'échantillonnage (Ta) pour un signal (10) analogique sous balayage, comprenant :
10.1 un générateur de séquencement (32) pour générer un signal d'horloge (33) formant l'horloge d'échantillonnage (Ta),
10.2 au moins un convertisseur AN (40), couplé au générateur de séquencement (32), pour scruter des valeurs (42) du signal analogique (10) à différents moments,
10.3 un dispositif pour effectuer une différentielle simple en fonction du temps du signal analogique (50),
10.4 au moins un convertisseur AN (45), couplé au générateur de séquencement (32), pour scruter le signal analogique (52), ayant été soumis à une différencielle en fonction du temps, à différents moments,
10.5 un module pour déterminer la position de phase (60), par :
10.5.1 la reconstruction, par approximations, de la forme du signal analogique (10) sur au moins une partie de la plage prédéterminée par les valeurs (42, 54) scrutées du signal analogique (10) et du signal analogique (52) différencié, du signal analogique (10), en utilisant au moins une partie des valeurs scrutées du signal analogique (42) et au moins une partie des valeurs scrutées du signal analogique (54) ayant subi une différencielle en fonction du temps,
10.5.2 la détermination d'un point zéro, le plus proche possible d'un moment de scrutation (12b), de la première dérivée en fonction du temps de la forme du signal reconstruite par approximations,
10.5.3 la détermination de la position de phase (82) de l'horloge d'échantillonnage (Ta) concernant le signal analogique (10), à partir de l'espacement temporel entre ce moment de scrutation (12b) et la position temporelle déterminée du point zéro,
10.6 un circuit de régulation (95, 90), pour le rattrapage de la position de phase (82) de l'horloge d'échantillonnage (Ta) concernant le signal analogique (10), à l'aide de la position de phase (82) déterminée dans le module pour la détermination de la position de phase (60).

11. Dispositif selon la revendication 10, **caractérisé en ce que** les convertisseurs AN (40, 45) sont couplés au générateur de séquencement (32) de manière que, à chaque valeur (42), scrutée à un moment donné, du signal analogique (10), la valeur (54) du signal (52) à ce moment ayant subi une différencielle en fonction du temps peut être scrutée.

12. Dispositif selon l'une des revendications 10 à 11, **caractérisé en ce que**, pour chaque valeur (42) du signal analogique (10) scrutée, utilisée pour la reconstruction par approximations de la forme du signal analogique (10), est à chaque fois prévu un registre de mémoire (62, 63, 64) et, pour chaque valeur (54), scrutée pour cette reconstruction, du signal analogique (52) ayant subi une différencielle en fonction du temps est également prévu un registre de mémoire (65, 66, 67), en particulier à chaque fois trois registres de mémoire.

13. Dispositif selon l'une des revendications 10 à 12, **caractérisé en ce que** le module de détermination de la position de phase (60) comprend un opérateur médian (69).

14. Dispositif selon l'une des revendications 10 à 13, **caractérisé en ce que** le module de détermination de la position de phase (60) comprend un microcontrôleur (80).

15. Dispositif selon l'une des revendications 10 à 14, **caractérisé en ce que** le circuit de régulation prévu pour le suvi de la position de phase (95, 90) comprend un circuit de régulation à verrouillage de retard (delay locked loop - DLL) (95).

16. Dispositif selon l'une des revendications 10 à 15, **caractérisé en ce que** le circuit de régulation prévu pour le suivi de la position de phase (95, 90) comprend un élément de régulation (90), en particulier un régulateur proportionnel-intégral (régulateur PI).
